# EUROPÄISCHE PATENTSCHRIFT

(11) **EP 1 537 655 B1**
(45) Veröffentlichungstag und Bekanntmachung des Hinweises auf die Patenterteilung: **16.03.2016**
(21) Anmeldenummer: 03769185.4
(22) Anmeldetag: 09.09.2003
(51) Int. Cl.: H03H 7/01, H01G 4/40

(54) **MEHRFACHRESONANZFILTER**
MULTIPLE RESONANCE FILTER
FILTRE DE RESONANCE MULTIPLE

(30) Priorität: 09.09.2002 DE 10241674
(43) Veröffentlichungstag der Anmeldung: 08.06.2005
(73) Patentinhaber: EPCOS AG, 81669 München (DE)
(72) Erfinder: ENGEL, Günter, 8430 Leibnitz (AT); FEICHTINGER, Thomas, 8010 Graz (AT); ORTNER, Markus, 8521 Wettmannstätten (AT); SPERLICH, Reinhard, 83059 Kolbermoor (DE)
(74) Vertreter: Epping - Hermann - Fischer
(86) Internationale Anmeldenummer: PCT/DE2003/002986
(87) Internationale Veröffentlichungsnummer: WO 2004/025831

(56) Entgegenhaltungen:
- EP-A- 1 079 520
- EP-A- 1 215 748
- US-A- 6 088 214
- US-B1- 6 304 156

## Beschreibung

Die Erfindung betrifft ein Mehrfachresonanzfilter, das mehrere Vielschichtkondensatoren enthält.

Aus der Druckschrift US 5898562 ist ein Mehrfachresonanzfilter bekannt, bei dem in einem Vielschichtbauelement zwei nebeneinanderliegende Vielschichtkondensatoren unterschiedlicher Kapazität integriert sind. Dieses Bauelement wird zur Dämpfung von Störsignalen bei zwei durch die Kapazitäten der beiden Kondensatoren vorgegebenen Frequenzen verwendet. Das bekannte Bauelement hat den Nachteil, das die Dämpfung relativ schlechte Werte aufweist.

Des weiteren sind aus den Druckschrift US 6,304,156 B1 und EP 1215748 A1 Mehrfachresonanzfilter bekannt.

Es ist daher Aufgabe der vorliegenden Erfindung, ein Mehrfachresonanzfilter anzugeben, das gute Dämpfungswerte aufweist.

Diese Aufgabe wird gelöst durch ein Mehrfachresonanzfilter gemäß Patentanspruch 1. Vorteilhafte Ausgestaltungen der Erfindung sind den weiteren Patentansprüchen zu entnehmen.

Es wird ein Mehrfachresonanzfilter angegeben, das ein elektrisches Vielschichtbauelement ist. Es enthält mindestens drei Vielschichtkondensatoren, die nebeneinander angeordnet sind. Die Vielschichtkondensatoren weisen dabei wenigstens zwei voneinander verschiedene Kapazitäten auf. Die beiden äußeren der in einer Reihe liegenden Vielschichtkondensatoren weisen dabei dieselbe Kapazität auf.

Durch den Aufbau des Mehrfachresonanzfilters mit nebeneinander in einer Reihe angeordneten Kondensatoren und durch das Ausbilden von Kondensatoren gleicher Kapazität an den beiden Rändern der Reihe kann erreicht werden, daß eine Entkopplung der elektromagnetischen Felder im Filter stattfindet, wodurch das Dämpfungsverhalten bei den einzelnen Resonanzfrequenzen des Filters verbessert wird.

Daraus ergibt sich der Vorteil, daß das Mehrfachresonanzfilter ein verbessertes Dämpfungsverhalten aufweist.

In einer vorteilhaften Ausführungsform des Mehrfachresonanzfilters sind die Vielschichtkondensatoren zueinander parallel geschaltet. Durch die Parallelschaltung können die Filtereigenschaften des Mehrfachresonanzfilters noch zusätzlich verbessert werden.

In einer Ausführungsform des Vielschichtbauelements ist ein Grundkörper vorgesehen, der einen Stapel aus übereinanderliegenden Dielektrikumschichten aufweist. Zwischen den Dielektrikumschichten sind Elektrodenschichten angeordnet. Diese Ausführungsform hat den Vorteil, daß zur Realisierung des Mehrfachresonanzfilters die an und für sich gut bekannte Technologie der Vielschichtkondensatoren genutzt werden kann.

Vielschichtkondensatoren sind im allgemeinen so aufgebaut, daß kammartig ineinandergreifende Elektrodenstapel im Inneren des Bauelements durch innenliegende Elektrodenschichten gebildet werden. Jeder Stapel von Innenelektroden ist gemeinsam mit einem Außenkontakt verbunden.

In einer Ausführungsform des Mehrfachresonanzfilters sind Außenkontakte der Elektrodenschichten an den Stirnseiten des Grundkörpers angeordnet.

In einer anderen Ausführungsform des Mehrfachresonanzfilters sind zu verschiedenen Kondensatoren gehörende Elektrodenschichten im Inneren des Grundkörpers miteinander verbunden. Dadurch kann in vorteilhafter Weise im Inneren des Grundkörpers, also im Inneren des Bauelements, eine Parallelschaltung der einzelnen Kondensatoren erfolgen.

In einer Ausführungsform des Mehrfachresonanzfilters verlaufen Elektrodenschichten in Längsrichtung des Grundkörpers. In einer anderen Ausführungsform verlaufen Elektrodenschichten quer zur Längsrichtung des Grundkörpers.

In einer Ausführungsform des Mehrfachresonanzfilters sind Außenkontakte der Elektrodenschichten an Seitenflächen des Grundkörpers angeordnet. Diese Ausführungsform des Filters erlaubt es, die Außenkontakte einzeln jedem einzelnen Kondensator des Vielschichtbauelements zuzuordnen und die gewünschte Verschältung der Kondensatoren untereinander erst auf der mit dem Bauelement zu bestückenden Platine vorzunehmen. Dadurch wird die Flexibilität der Einsatzmöglichkeiten des Bauelements vorteilhafterweise erhöht.

Insbesondere wird es dadurch ermöglicht, daß die Vielschichtkondensatoren außerhalb des Grundkörpers zueinander parallel geschaltet werden.

In einer Ausführungsform des Filters sind drei Vielschichtkondensatoren vorgesehen. In einer anderen Ausführungsform des Filters sind vier Vielschichtkondensatoren vorgesehen, wobei die beiden mittleren Vielschichtkondensatoren dieselbe Kapazität aufweisen.

In einer Ausführungsform des Filters bilden die Vielschichtkondensatoren zusammen mit den Induktivitäten der Elektrodenschichten bzw. zusammen mit den Induktivitäten der Zuleitungen zu den Elektrodenschichten LC-Filter. Durch die Hinzunahme von Induktivitäten zu dem Bauelement können die Filtereigenschaften des Bauelements weiter verbessert werden. Indem der Hauptbeitrag der für das Filter benötigten Induktivitäten von den Zuleitungen und den Elektrodenschichten herrührt, ist es möglich, die Induktivität durch eine entsprechende Ausgestaltung der Elektrodenschichten bzw. der Zuleitungen zu den Elektrodenschichten auf ein gewünschtes Maß einzustellen.

In einer Ausführungsform des Filters enthalten die Dielektrikumschichten eine Kondensatorkeramik auf der Basis von Bariumtitanat. Beispielsweise kommt als Dielektrikumschicht eine sogenannte "COG"-Keramik in Betracht. Ein solches Material wäre beispielsweise eine (Ba, Sm) NdTiO₆-Keramik. Es kommt aber auch eine "X7R"-Keramik in Betracht, beispielsweise dotiertes Bariumtitanat.

In einer anderen Ausführungsform enthalten die Dielektrikumschichten ein Kondensatormaterial mit Varistoreffekt.

Als Keramikmaterial mit Varistoreffekt kommt beispielsweise ein Keramikmaterial auf der Basis von ZnO-Bi oder ZnO-Pr in Betracht. Solche Dielektrikumschichten haben den Vorteil, daß sie neben dem Kondensator noch als weiteres Bauelement einen Varistor in das Vielschichtbauelement integrieren.

Es ist darüber hinaus auch möglich, Kondensatorkeramiken und Keramiken mit Varistoreffekt innerhalb eines einzigen Bauelements miteinander zu kombinieren.

In einer Ausführungsform des Filters weist der Grundkörper eine Grundfläche auf, die kleiner als 6 mm² ist. Diese Ausführungsform hat den Vorteil, daß der Platzbedarf des Bauelements sehr klein ist, was vorteilhaft für miniaturisierte Schaltungen ist.

In einer Ausführungsform des Filters weisen Elektrodenschichten, die zu den beiden äußeren Vielschichtkondensatoren gehören, gleiche Flächen auf. Diese Ausführungsform hat den Vorteil, daß die Forderung nach gleichen Kapazitäten der äußeren Vielschichtkondensatoren durch gleiche Flächen besonders leicht realisiert werden kann.

Im Folgenden wird die Erfindung anhand von Ausführungsbeispielen und den dazugehörigen Figuren näher erläutert:
Figur 1 zeigt ein Mehrfachresonanzfilter in einem schematischen Querschnitt.
Figur 2 zeigt die Einfügedämpfung des Bauelements aus Figur 1.
Figur 3 zeigt beispielhaft ein weiteres Mehrfachresonanzfilter in einer perspektivischen Außenansicht, wobei die Außenansicht mehrere Möglichkeiten für die innere Struktur umfaßt.
Figuren 31, 31A, 31D zeigen beispielhaft die innere Struktur für ein Bauelement mit einer äußeren Struktur gemäß Figur 3.
Figuren 32, 32A, 32D zeigen die innere Struktur eines weiteren Filters, dessen äußere Struktur in Figur 3 dargestellt ist.
Figuren 33, 33A, 33D zeigen beispielhaft eine innere Struktur eines weiteren Bauelements, dessen äußere Struktur in Figur 3 gezeigt ist.
Figuren 34, 34A, 34D zeigen beispielhaft die innere Struktur eines weiteren Filters, wobei dessen äußere Struktur durch Figur 3 gegeben ist.

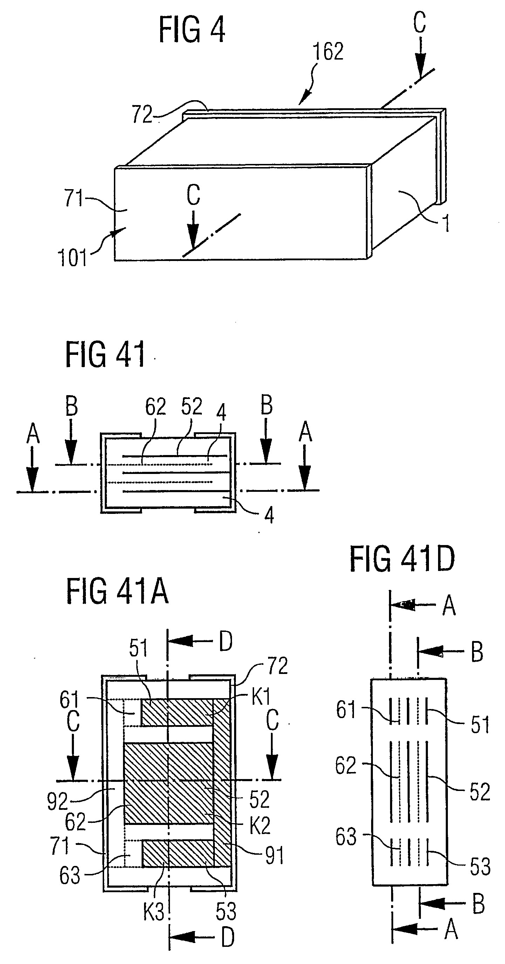

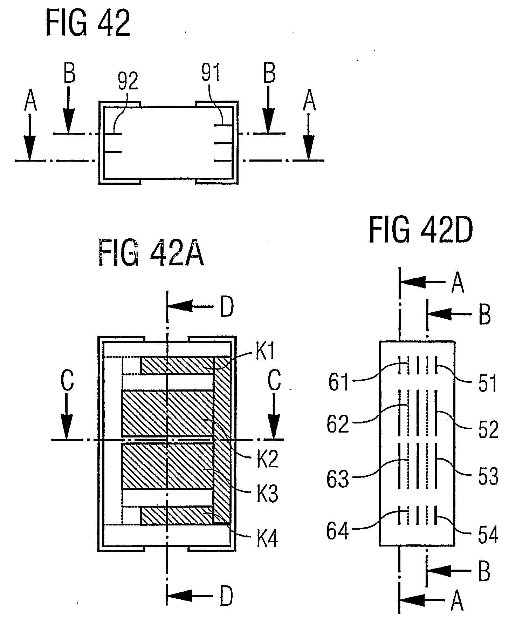

Figur 4 zeigt beispielhaft die äußere Struktur für ein Filter, wobei diese Struktur für Filter, deren innere Struktur in den Figuren 41, 41A und 41D sowie in den Figuren 42, 42A und 42D gezeigt ist, gilt.
Figuren 41, 41A, 41D zeigen die innere Struktur für eine Ausführungsform des Filters, dessen äußere Struktur durch Figur 4 gegeben ist.
Figuren 42, 42A, 42D zeigen die innere Struktur für ein weiteres Filter, dessen äußere Struktur durch Figur 4 gegeben ist.

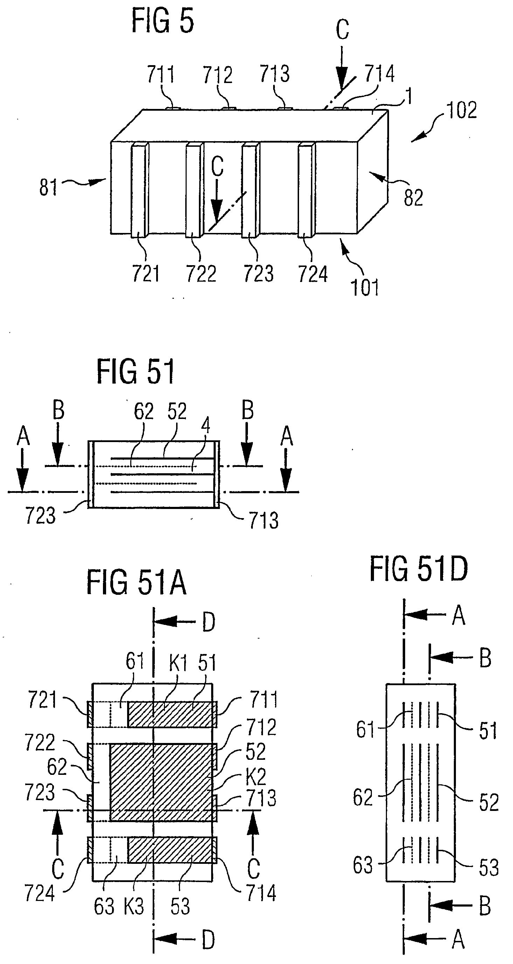

Figur 5 zeigt die äußere Struktur eines Filters beispielhaft in einer perspektivischen Ansicht, wobei die äußere Struktur für eine Vielzahl von inneren Strukturen gültig ist.
Figuren 51, 51A, 51D zeigen die innere Struktur eines Filters, dessen äußere Struktur durch Figur 5 gegeben ist.

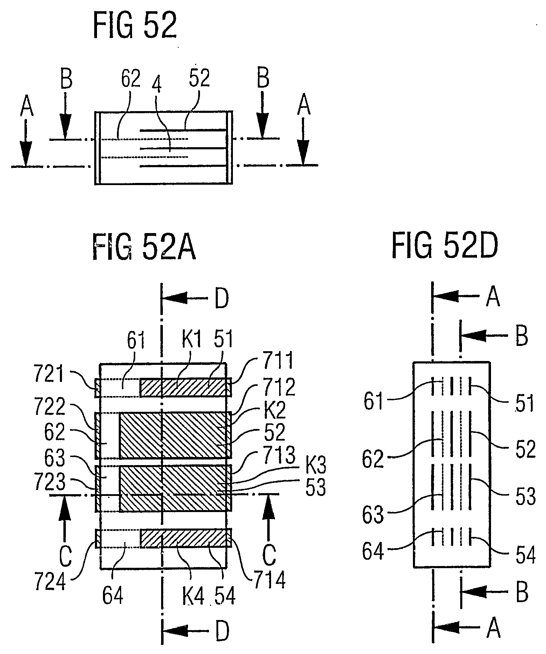

Figuren 52, 52A, 52D zeigen die innere Struktur eines weiteren Filters, dessen äußere Struktur durch Figur 5 gegeben ist.

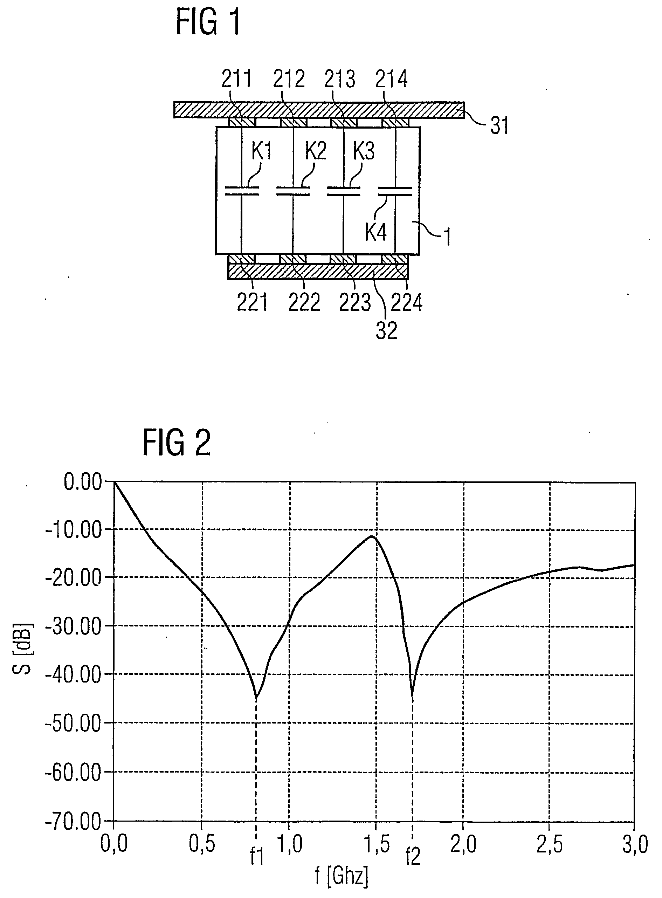

Figur 1 zeigt ein Mehrfachresonanzfilter, das einen Grundkörper 1 aufweist. Im Inneren des Grundkörpers 1 sind Kondensatoren K1, K2, K3, K4 nebeneinanderliegend in einer Reihe angeordnet. Jeder der Kondensatoren K1, K2, K3, K4 ist jeweils mit einem ersten Kondensatoranschluß 211, 212, 213, 214 und mit einem zweiten Kondensatoranschluß 221, 222, 223, 224 verbunden. Die jeweils zu einem Kondensator K1, K2, K3, K4 gehörenden ersten Kondensatoranschlüsse 211, 212, 213, 214 sind durch einen Kontakt 31 miteinander elektrisch leitend verbunden. Die zu jeweils einem Kondensator K1, K2, K3, K4 gehörenden zweiten Kondensatoranschlüsse 221, 222, 223, 224 sind durch einen Kontakt 32 elektrisch leitend miteinander verbunden. Durch die Kontakte 31, 32 wird eine parallele Schaltung der Kondensatoren K1, K2, K3, K4 realisiert. Die Kondensatoren K1, K2, K3, K4 sind hinsichtlich ihrer Kapazität C1, C2, C3 so ausgeführt, daß die Kondensatoren K1 und K4 die Kapazität C1 aufweisen, also in der Kapazität gleich sind. Die Kondensatoren K2 und K3 weisen die Kapazität C2 und C3 auf. Die Kapazitäten C2, C3 können gleich oder auch voneinander verschieden sein.

Figur 2 zeigt das Dämpfungsverhalten des Mehrfachresonanzfilter aus Figur 1 für den Fall, daß die beiden Kondensatoren K2 und K3 aus Figur 1 die gleiche Kapazität C2 aufweisen. In Figur 2 ist die Dämpfung S in der Einheit Dezibel aufgetragen über die Frequenz f, gemessen in GHz, eines elektrischen Signals, welches an das Filter angelegt wurde. Es ist in Figur 2 zu erkennen, daß bei den Resonanzfrequenzen f1 und f2 eine sehr hohe Dämpfung kleiner als -40 dB gemessen wurde. Dies zeigt, daß das Mehrfachresonanzfilter, welches in dieser Anmeldung beschrieben wird, sehr gute Dämpfungseigenschaften hat. Die beiden Resonanzfrequenzen f1, f2, bei denen die Minima in der Dämpfungskurve auftreten, sind dabei durch die Kapazitäten C1 und C2 der Kondensatoren K1, K2, K3, K4 gegeben.

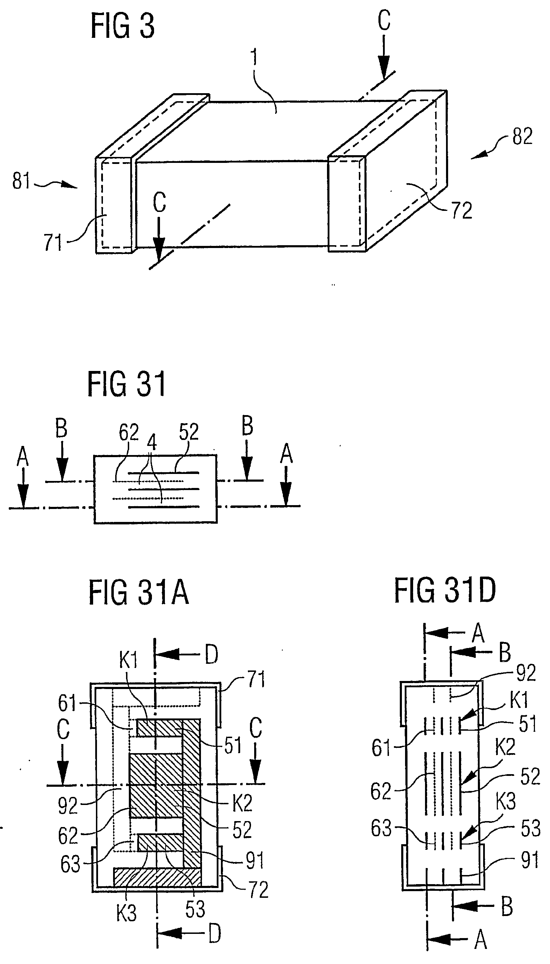

Figur 3 zeigt die äußere Struktur eines Mehrfachresonanzfilters, bei dem die Außenkontakte 71, 72 an den Stirnseiten des Grundkörpers 1 kappenförmig angeordnet sind. Die kappenförmige Anordnung der Außenkontakte 71, 72 hat den Vorteil, daß das Bauelement für die Oberflächenmontagetechnik geeignet ist. Dabei ist der Außenkontakt 71 an der Stirnfläche 81 des Grundkörpers 1 und der Außenkontakt 72 an der Stirnseite 82 des Grundkörpers 1 aufgebracht.

Die Figur 31 zeigt einen Schnitt entlang der Linie C-C von Figur 3. Es sind die übereinanderliegenden Dielektrikumschichten 4 zu erkennen, die durch Elektrodenschichten 52, 62 voneinander getrennt sind. Da in dem Beispiel von Figur 31 die Kontaktierung der Elektrodenschichten 52, 62 über die Stirnseiten des Grundkörpers erfolgt, sind in Figur 31 die Elektrodenschichten 52, 62 nicht bis zum äußeren seitlichen Rand des Grundkörpers hinausgezogen. Die Elektrodenschichten 52 gehören dabei zu einem Vielschichtkondensator, wobei die Elektroden 52 alle miteinander parallel verschaltet sind. Die Elektrodenschichten 62, die ihrerseits ebenso wie die Elektrodenschichten 52 übereinandergestapelt sind, gehören ebenfalls zu demselben Vielschichtkondensator wie die Elektrodenschichten 52 und sind seitlich zu den Elektrodenschichten 52 versetzt angeordnet. Aus Figur 31 geht auch das kammartige Ineinandergreifen der Elektrodenschichten 52 und 62 hervor. In Figur 31 sind die Elektrodenschichten 52 durch durchgezogene Striche gekennzeichnet, während die Elektrodenschichten 62 durch jeweils eine gepunktete Linie gekennzeichnet sind. Dies gilt in analoger Art und Weise für die Figuren 31D, 32, 32D, 33, 33D, 34, 34D, 41, 41D, 42, 42D, 51, 51D, 52 und 52D.

Die hier beschriebenen Vielschichtkondensatoren sind prinzipiell alle so aufgebaut, wie in Figur 31 gezeigt. Dies gilt insbesondere für das kammartige Ineinandergreifen der Elektrodenschichten.

Figur 31A zeigt einen Schnitt entlang der Linie A-A aus Figur 31. Es ist erkennbar, daß im Inneren des Vielschichtbauelements drei Vielschichtkondensatoren K1, K2, K3 angeordnet sind. Die beiden äußeren Kondensatoren K1, K3 weisen dabei Elektrodenschichten 51, 53 bzw. 61, 63 auf, die gleiche Flächen haben. Daher haben die Kondensatoren K1 und K3 dieselbe Kapazität. Der Vielschichtkondensator K2, der in der Mitte der Reihe von Kondensatoren K1, K2, K3 angeordnet ist, weist dagegen Elektrodenschichten 52, 62 auf, welche größer sind als die Elektrodenschichten 51, 61, 53, 63. Entsprechend hat der Kondensator K2 eine größere Kapazität als die Kondensatoren K1 und K3. In Figur 31A sind die in der Schnittebene liegenden Elektroden als schraffierte Flächen, welche von durchgezogenen Linien begrenzt sind, dargestellt. In einer darüber- oder darunterliegenden Ebene angeordnete Elektrodenschichten, dies sind insbesondere die Elektrodenschichten 61, 62, 63 sowie das innere Verbindungselement 92, sind durch Flächen, die von gestrichelten Linien begrenzt werden, dargestellt. In Figur 31A ist gezeigt, daß die Elektrodenschichten 51, 52, 53 durch ein inneres Verbindungselement 91 miteinander verbunden sind. Das innere Verbindungselement 91 kann in derselben Art und Weise wie die Elektrodenschichten 51, 52, 53 gebildet sein. Es kann beispielsweise in Vielschichttechnik aus einer metallhaltigen Paste gebildet sein. Das Verbindungselement 91 ist unmittelbar mit dem Außenkontakt 72 kontaktiert. Entsprechend gibt es für die Elektrodenschichten 61, 62, 63 ein inneres Verbindungselement 92, das diese Elektrodenschichten 61, 62, 63 miteinander elektrisch leitend verbindet. Das innere Verbindungselement 92 ist mit dem Außenkontakt 71 elektrisch leitend verbunden. Dadurch wird eine innere Parallelschaltung der Kondensatoren K1, K2, K3 realisiert.

Figur 31D zeigt einen Schnitt entlang der Linie D-D aus Figur 31A. Es ist in einer analogen Darstellung wie in Figur 31 zu erkennen, daß es für jeden Kondensator übereinandergestapelte Elektrodenschichten 51, 52, 53 (für den ersten Kontakt der Kondensatoren, mit durchgezogenen Linien gekennzeichnet) bzw. übereinandergestapelte Elektrodenschichten 61, 62, 63 (für den zweiten Kontakt des jeweiligen Kondensators, mit gestrichelten Linien gekennzeichnet) gibt. Die übereinandergestapelten Elektrodenschichten 51, 61 sowie 52, 62 und 53, 63 bilden jeweils einen Vielschichtkondensator K1, K2, K3. Es sind ferner die Verbindungselemente 91, 92 in Figur 31D gezeigt. Es ist dabei zu beachten, daß in der Darstellung von Figur 31D auch die Verbindungselemente 91, 92 in einer Vielzahl als Stapel von Verbindungselementen 91, 92 übereinandergestapelt dargestellt sind.

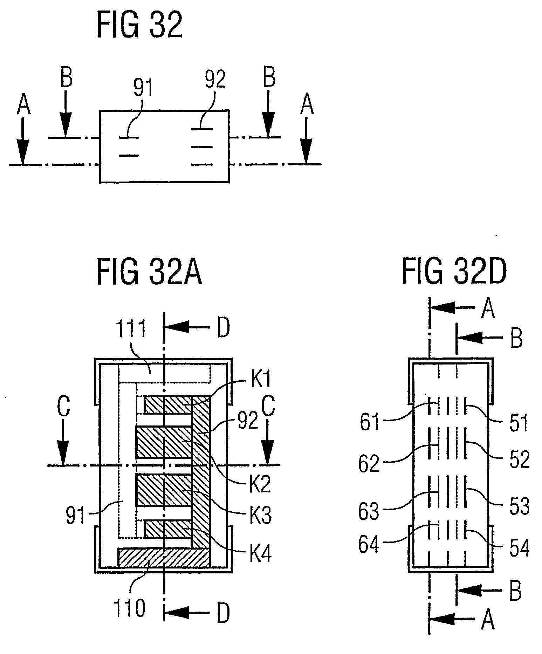

Figur 32 zeigt den inneren Aufbau eines Mehrfachresonanzfilters entsprechend Figur 31, jedoch mit dem Unterschied, daß nur die inneren Verbindungselemente 91, 92 dargestellt sind. Die inneren Verbindungselemente 91 sind als gestrichelte Linien dargestellt. Die inneren Verbindungselemente 92 sind als durchgezogene Linien dargestellt. Figur 32A zeigt einen Schnitt entlang der Linie A-A aus Figur 32. Es ist in analoger Art und Weise wie in Figur 31A zu erkennen, daß das Mehrfachresonanzfilter aus vier Kondensatoren K1, K2, K3, K4 besteht, welche in einer zu Figur 31A, Figur 31D und Figur 31 analogen Art und Weise aufgebaut sind. Der Unterschied zwischen den Figuren 32, 32A und 32D zu den Figuren 31, Figur 31A und Figur 31D besteht lediglich in der Anzahl von Kondensatoren. In Figur 32A ist noch eine Zuleitung 110 bzw. eine Zuleitung 111 gezeigt, woraus hervorgeht, daß mit Hilfe der Zuleitungen 110, 111 Induktivitäten in das Bauelement integriert werden können. Dabei werden die Induktivitäten über die Länge der Zuleitungen 110, 111 bestimmt. Die Zuleitungen 110, 111 haben dabei die Aufgabe der inneren Verbindungselemente 91, 92. Es ist dabei zu beachten, daß die Induktivitäten des Bauelements auch noch von den Formen und Flächen der Elektrodenschichten 51, 52, 53, 54 bzw. 61, 62, 63, 64, wie sie in Figur 32A als Draufsicht und in Figur 32D im Querschnitt dargestellt sind, abhängen.

Die Figur 32D zeigt einen Schnitt entlang der Linie D-D von Figur 32A. Es sind noch mal vier übereinandergestapelte Elektrodenschichten 51, 61 bzw. 52, 62 bzw. 53, 63 und 54, 64 dargestellt. Der Aufbau ist wieder entsprechend dem Aufbau von Figur 31D dargestellt.

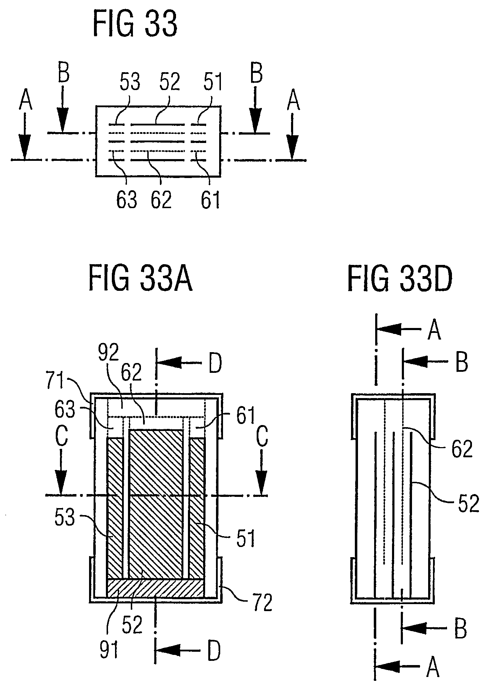

Die Figuren 33, 33A und 33D zeigen ein Mehrfachresonanzfilter entsprechend den Figuren 31, 31A, 31D bzw. entsprechend den Figuren 32, 32A, 32D mit dem Unterschied, daß die Elektrodenschichten 51, 52, 53 bzw. 61, 62, 63 bei dem Ausführungsbeispiel gemäß den Figuren 33, 33A, 33D nicht quer zur Längsrichtung des Grundkörpers, sondern in dieser Längsrichtung verlaufen. Dementsprechend ist die Länge des inneren Verbindungselements 91, 92 verkürzt, wobei jedoch die Länge der Elektrodenschichten 51, 52, 53 bzw. 61, 62, 63 vergrößert ist. Die verschiedenen Ausführungsbeispiele hinsichtlich der Orientierung der Elektrodenschichten 51, 52, 53, 54 bzw. 61, 62, 63, 64 zeigen, daß man bei der Gestaltung der Kapazitäten bzw. Induktivitäten für das Mehrfachresonanzfilter einen großen Spielraum hat. Ansonsten entspricht die Darstellung der Figuren 33, 33A, 33D den Beispielen aus den Figuren 31, 31A, 31D.

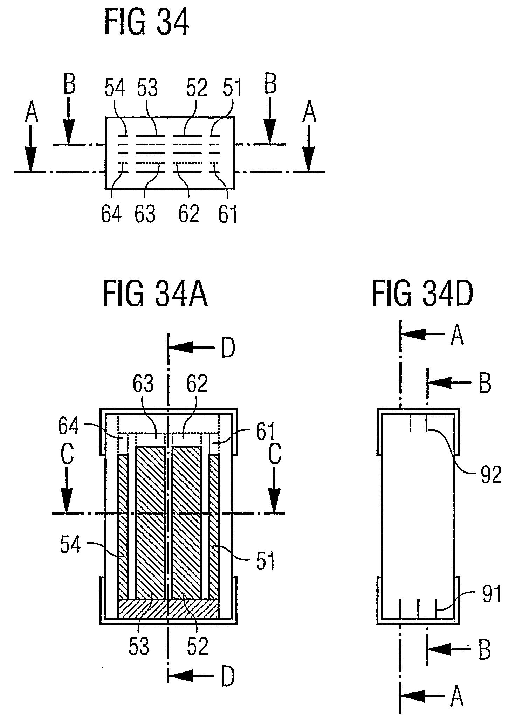

Die Figuren 34, 34A, 34D zeigen eine Ausführungsform des Mehrfachresonanzfilters entsprechend den Figuren 33, 33A, 33D mit dem Unterschied, daß vier anstelle von drei Vielschichtkondensatoren in dem Bauelement ausgebildet sind.

Figur 4 zeigt eine äußere Struktur für eine Gruppe von Mehrfachresonanzfiltern, wobei beispielhaft für diese Gruppe in den Figuren 41, 41A, 41D sowie 42, 42A, 42D Ausführungsformen für die Innenstruktur gezeigt sind. Figur 4 zeigt das Mehrfachresonanzfilter mit dem Grundkörper 1, an dessen Seitenflächen 101, 102 Außenkontakte 71, 72 angeordnet sind.

Figur 41 zeigt einen Schnitt entlang der Linie C-C von Figur 4. Es sind analog zur Darstellung in den Figuren 31, 32, 33, 34 Stapel von übereinanderliegen Dielektrikumschichten 4 sowie Elektrodenschichten 52, 62 dargestellt. Die in den Figuren 41, 41A und 41D gezeigten Ansichten des Mehrfachresonanzfilters unterscheiden sich von der Darstellung in den Figuren 31, 31A, 31D lediglich dadurch, daß die Kontaktierung der Kondensatoren nicht von den Stirnflächen des Grundkörpers, sondern von den Seitenflächen des Grundkörpers her erfolgt. Entsprechend ist die Länge der Zuleitungen 110, 111 z. B. bei den Figuren 41, 41A, 41D verkürzt, weswegen bei dieser Ausführungsform die Induktivität des Bauelements verringert ist. Die Figuren 41A, 41D zeigen jeweils Schnittansichten, wie sie in analoger Weise den Figuren 31A, 31D entsprechen.

Die Figuren 42, 42A, 42D zeigen eine Ausführungsform für das Mehrfachresonanzfilter entsprechend den Figuren 41, 41A, 41D, mit dem Unterschied, daß eine Vielzahl von vier Kondensatoren K1, K2, K3, K4 anstelle von drei Kondensatoren im Inneren des Bauelements ausgebildet ist. Ansonsten entsprechen die Darstellungen in den Figuren 42, 42A, 42D den Darstellungen in den Figuren 41, 41A, 41D.

Figur 5 zeigt eine äußere Struktur für ein Mehrfachresonanzfilter, wobei ein Grundkörper 1 vorgesehen ist. Der Grundkörper 1 weist Stirnseiten 81, 82 auf. Der Grundkörper 1 weist auch Seitenflächen 101, 102 auf. An jeder Seitenfläche 101, 102 sind jeweils vier Außenkontakte 711, 712, 713, 714 bzw. 721, 722, 723, 724 angeordnet. Dabei gehört jedes gegenüberliegende Paar von Außenkontakten 711, 721 bzw. 712, 722 bzw. 713, 723 bzw. 714, 724 zu einem Kondensator im Inneren des Grundkörpers 1.

Figur 51 zeigt einen Schnitt entlang der Linie C-C von Figur 5. Die Darstellung in den Figuren 51, 51A, 51D entspricht der Darstellung in den Figuren 41, 41A, 41D, mit dem Unterschied, daß hier die Verbindungselemente 91, 92 fehlen, da jeder einzelne Kondensator K1, K2, K3 einzeln mit Außenkontakten 711, 712, 713, 714 bzw. 721, 722, 723, 724 (vergleiche Figur 51A) verbunden ist. Im übrigen entspricht die Darstellung in den Figuren 51, 51A, 51D der Darstellung in den Figuren 41, 41A, 41D.

Die Figuren 52, 52A, 52D zeigen die innere Struktur eines Mehrfachresonanzfilters, wie es mit einer Außenstruktur entsprechend Figur 5 ausgebildet werden kann. Die Darstellung in den Figuren 52, 52A, 52D entspricht der Darstellung in den Figuren 51, 51A, 51D, mit dem Unterschied, daß vier Vielschichtkondensatoren K1, K2, K3, K4 anstelle von drei Kondensatoren K1, K2, K3 entlang des Bauelements angeordnet sind. Indem die beiden mittleren Kondensatoren K2, K3 hinsichtlich ihrer Elektrodenschichten 52, 53 bzw. 62, 63 so ausgebildet sind, daß sie dieselbe Kapazität C2 aufweisen, kann das Dämpfungsverhalten bei der zweiten Resonanzfrequenz f2 noch mal deutlich verbessert werden.

Die Erfindung beschränkt sich nicht auf Mehrfachresonanzfilter mit zwei Filterfrequenzen, sondern kann auf Mehrfachresonanzfilter mit einer Vielzahl verschiedener Resonanzfrequenzen angewendet werden.

### Bezugszeichenliste

1 Grundkörper
211, 212, 213, 214 erste Kondensatoranschlüsse
221, 222, 223, 223 zweite Kondensatoranschlüsse
31, 32 Kontakt
4 Dielektrikumschicht
51, 52, 53, 54 Elektrodenschicht
61, 62, 63, 64 Elektrodenschicht
711, 712, 713, 714 Außenkontakt
721, 722, 723, 724 Außenkontakt
71, 72 Außenkontakt
81, 82 Stirnseite
91, 92 inneres Verbindungselement
101, 102 Seitenfläche
110, 111 Zuleitung
C1, C2, C3 Kapazität
K1, K2, K3, K4 Kondensator
S Einfügedämpfung
f Frequenz
f1, f2 Resonanzfrequenz

## Patentansprüche

1. Mehrfachresonanzfilter als Vielschichtbauelement,
- enthaltend mindestens drei nebeneinander liegende Vielschichtkondensatoren (K1, K2, K3, K4) mit mindestens zwei verschiedenen Kapazitäten (C1, C2, C3),
- wobei die beiden äußeren Vielschichtkondensatoren (K1, K4) dieselbe Kapazität (C1) aufweisen,
- wobei Induktivitäten des Mehrfachresonanzfilters durch Elektrodenschichten der Vielschichtkondensatoren (K1, K4) gebildet sind, und
- die Elektrodenschichten kammartig ineinander greifen.

2. Filter nach Anspruch 1,
- bei dem die Vielschichtkondensatoren (K1, K2, K3, K4) zueinander parallel geschaltet sind.

3. Filter nach einem der Ansprüche 1 oder 2,
- das einen Grundkörper (1) aufweist und das einen Stapel aus übereinanderliegenden Dielektrikumschichten (4) mit dazwischenliegenden Elektrodenschichten (51, 52, 53, 54; 61, 62, 63, 64) aufweist.

4. Filter nach Anspruch 3,
- bei dem Außenkontakte (71, 72) der Elektrodenschichten (51, 52, 53, 54; 61, 62, 63, 64) an den Stirnseiten (81, 82) des Grundkörpers (1) angeordnet sind.

5. Filter nach einem der Ansprüche 3 bis 4,
- bei dem zu verschiedenen Kondensatoren (K1, K2, K3, K4) gehörende Elektrodenschichten (51, 52, 53, 54; 61, 62, 63, 64) im Inneren des Grundkörpers (1) miteinander verbunden sind.

6. Filter nach einem der Ansprüche 3 bis 5,
- bei dem Elektrodenschichten (51, 52, 53, 54; 61, 62, 63, 64) in Längsrichtung des Grundkörpers (1) verlaufen.

7. Filter,nach einem der Ansprüche 3 bis 5,
- bei dem Elektrodenschichten (51, 52, 53, 54; 61, 62, 63, 64) quer zur Längsrichtung des Grundkörpers (1) verlaufen.

8. Filter nach einem der Ansprüche 3 bis 6,
- bei dem Außenelektroden (711, 712, 713, 714; 721, 722, 723, 724, 71, 72) der Elektrodenschichten (51, 52, 53, 54; 61, 62, 63, 64) an Seitenflächen (101, 102) des Grundkörpers (1) angeordnet sind.

9. Filter nach einem der Ansprüche 3 bis 7,
- bei dem die Vielschichtkondensatoren (K1, K2, K3, K4) außerhalb des Grundkörpers (1) zueinander parallel geschaltet sind.

10. Filter nach einem der Ansprüche 1 bis 9,
- bei dem drei Vielschichtkondensatoren (K1, K2, K3) vorgesehen sind.

11. Filter nach einem der Ansprüche 1 bis 9,
- bei dem vier Vielschichtkondensatoren (K1, K2, K3, K4) vorgesehen sind, wobei die beiden mittleren Vielschichtkondensatoren (K2, K3) dieselbe Kapazität (C2) aufweisen.

12. Filter nach einem der Ansprüche 1 bis 11,
- bei dem die Vielschichtkondensatoren (K1, K2, K3, K4) zusammen mit Induktivitäten der Elektrodenschichten (51, 52, 53, 54; 61, 62, 63, 64) und der Zuleitungen (110, 111) LC-Filter bilden.

13. Filter nach einem der Ansprüche 3 bis 12,
- bei dem die Dielektrikumschichten (4) eine Kondensatorkeramik auf der Basis von Bariumtitanat enthalten.

14. Filter nach einem der Ansprüche 3 bis 13,
- bei dem die Elektrodenschichten ein Keramikmaterial mit Varistoreffekt enthalten.

15. Filter nach einem der Ansprüche 3 bis 14,
- bei dem der Grundkörper (1) eine Grundfläche aufweist, die kleiner als 6 mm² ist.

16. Filter nach einem Ansprüche 3 bis 15,
- bei dem Elektrodenschichten (51, 52, 53, 54; 61, 62, 63, 64), die zu den beiden äußeren Vielschichtkondensatoren (K1, K4) gehören, gleiche Flächen aufweisen.

## Claims

1. Multiple resonance filter as a multilayer component
- comprising at least three multilayer capacitors (K1, K2, K3, K4) lying next to one another and having at least two different capacitances (C1, C2, C3),
- the two outer multilayer capacitors (K1, K4) having the same capacitance (C1),
- inductors of the multiple resonance filter being formed by electrode layers of the multilayer capacitors (K1, K4), and
- the electrode layers engaging in one another in a comb-like manner.

2. Filter according to Claim 1,
- in which the multilayer capacitors (K1, K2, K3, K4) are connected parallel to one another.

3. Filter according to either of Claims 1 and 2,
- which has a main body (1) and has a stack of dielectric layers (4) lying one on top of the other with electrode layers (51, 52, 53, 54; 61, 62, 63, 64) lying in between.

4. Filter according to Claim 3,
- in which external contacts (71, 72) of the electrode layers (51, 52, 53, 54; 61, 62, 63, 64) are arranged on the end faces (81, 82) of the main body (1).

5. Filter according to either of Claims 3 and 4,
- in which electrode layers (51, 52, 53, 54; 61, 62, 63, 64) belonging to different capacitors (K1, K2, K3, K4) are connected to one another inside the main body (1).

6. Filter according to one of Claims 3 to 5,
- in which electrode layers (51, 52, 53, 54; 61, 62, 63, 64) run in the longitudinal direction of the main body (1).

7. Filter according to one of Claims 3 to 5,
- in which electrode layers (51, 52, 53, 54; 61, 62, 63, 64) run transversely to the longitudinal direction of the main body (1).

8. Filter according to one of Claims 3 to 6,
- in which outer electrodes (711, 712, 713, 714; 721, 722, 723, 724, 71, 72) of the electrode layers (51, 52, 53, 54; 61, 62, 63, 64) are arranged on side faces (101, 102) of the main body (1).

9. Filter according to one of Claims 3 to 7,
- in which the multilayer capacitors (K1, K2, K3, K4) are connected parallel to one another outside the main body (1).

10. Filter according to one of Claims 1 to 9,
- in which three multilayer capacitors (K1, K2, K3) are provided.

11. Filter according to one of Claims 1 to 9,
- in which four multilayer capacitors (K1, K2, K3, K4) are providepd, the two middle multilayer capacitors (K2, K3) having the same capacitance (C2).

12. Filter according to one of Claims 1 to 11,
- in which the multilayer capacitors (K1, K2, K3, K4) together with inductors of the electrode layers (51, 52, 53, 54; 61, 62, 63, 64) and the supply leads (110, 111) form LC filters.

13. Filter according to one of Claims 3 to 12,
- in which the dielectric layers (4) comprise a capacitor ceramic on the basis of barium titanate.

14. Filter according to one of Claims 3 to 13,
- in which the electrode layers comprise a ceramic material with a varistor effect.

15. Filter according to one of Claims 3 to 14,
- in which the main body (1) has a main area that is smaller than 6 mm².

16. Filter according to one of Claims 3 to 15,
- in which electrode layers (51, 52, 53, 54; 61, 62, 63, 64) that belong to the two outer multilayer capacitors (K1, K4) have the same areas.

## Revendications

1. Filtre de résonance multiple en tant que composant multicouches,
- contenant au moins trois condensateurs multicouches (K1, K2, K3, K4) situés les uns à côté des autres avec au moins deux capacités (C1, C2, C3) différentes,
- dans lequel les deux condensateurs multicouches extérieurs (K1, K4) présentent la même capacité (C1),
- dans lequel des inductances du filtre de résonance multiple sont formées par des couches d'électrode des condensateurs multicouches (K1, K4), et
- les couches d'électrode se mettant en prise les unes avec les autres à la manière d'un peigne.

2. Filtre selon la revendication 1,
- dans lequel les condensateurs multicouches (K1, K2, K3, K4) sont couplés parallèlement les uns aux autres.

3. Filtre selon l'une des revendications 1 ou 2,
- lequel présente un corps de base (1) et lequel présente une pile de couches diélectriques (4) superposées avec des couches d'électrode (51, 52, 53, 54 ; 61, 62, 63, 64) situées entre celles-ci.

4. Filtre selon la revendication 3,
- dans lequel des contacts extérieurs (71, 72) des couches d'électrode (51, 52, 53, 54 ; 61, 62, 63, 64) sont disposés sur les côtés frontaux (81, 82) du corps de base (1).

5. Filtre selon l'une des revendications 3 à 4,
- dans lequel des couches d'électrode (51, 52, 53, 54 ; 61, 62, 63, 64) appartenant à différents condensateurs (K1, K2, K3, K4) sont reliées les unes aux autres à l'intérieur du corps de base (1).

6. Filtre selon l'une des revendications 3 à 5,
- dans lequel des couches d'électrode (51, 52, 53, 54 ; 61, 62, 63, 64) s'étendent en direction longitudinale du corps de base (1).

7. Filtre selon l'une des revendications 3 à 5,
- dans lequel des couches d'électrode (51, 52, 53, 54 ; 61, 62, 63, 64) s'étendent transversalement à la direction longitudinale du corps de base (1).

8. Filtre selon l'une des revendications 3 à 6,
- dans lequel des électrodes extérieures (711, 712, 713, 714 ; 721, 722, 723, 724, 71, 72) des couches d'électrode (51, 52, 53, 54 ; 61, 62, 63, 64) sont disposées sur des surfaces latérales (101, 102) du corps de base (1).

9. Filtre selon l'une des revendications 3 à 7,
- dans lequel les condensateurs multicouches (K1, K2, K3, K4) sont couplés parallèlement les uns aux autres en-dehors du corps de base (1).

10. Filtre selon l'une des revendications 1 à 9,
- dans lequel trois condensateurs multicouches (K1, K2, K3) sont prévus.

11. Filtre selon l'une des revendications 1 à 9,
- dans lequel quatre condensateurs multicouches (K1, K2, K3, K4) sont prévus, dans lequel les deux condensateurs multicouches (K2, K3) du milieu présentent la même capacité (C2).

12. Filtre selon l'une des revendications 1 à 11,
- dans lequel les condensateurs multicouches (K1, K2, K3, K4) forment, ensemble avec des inductances des couches d'électrode (51, 52, 53, 54 ; 61, 62, 63, 64) et les câbles d'alimentation (110, 111), des filtres LC.

13. Filtre selon l'une des revendications 3 à 12,
- dans lequel les couches diélectriques (4) contiennent une céramique de condensateur sur la base de titanate de baryum.

14. Filtre selon l'une des revendications 3 à 13,
- dans lequel les couches d'électrode contiennent un matériau de céramique avec un effet de varistance.

15. Filtre selon l'une des revendications 3 à 14,
dans lequel le corps de base (1) présente une surface de base qui est inférieure à 6 mm².

16. Filtre selon l'une des revendications 3 à 15,
- dans lequel des couches d'électrode (51, 52, 53, 54 ; 61, 62, 63, 64), lesquelles font partie des deux condensateurs multicouches extérieurs (K1, K4), présentent des surfaces identiques.
